# EUROPEAN PATENT SPECIFICATION

(11) **EP 4 329 140 B1**
(45) Date of publication and mention of the grant of the patent: **29.04.2026**
(21) Application number: 23743440.2
(22) Date of filing: 17.01.2023
(51) Int. Cl.: H02J 7/00, H01M 10/44, G01R 31/3835, B60L 58/12, B60L 58/16, H01M 10/48

(54) **BATTERY CONTROL APPARATUS AND METHOD**
VORRICHTUNG UND VERFAHREN ZUR STEUERUNG EINER BATTERIE
APPAREIL ET PROCÉDÉ DE COMMANDE DE BATTERIE

(30) Priority: 18.01.2022 KR 20220007443
(43) Date of publication of application: 28.02.2024
(73) Proprietor: LG Energy Solution, Ltd., Seoul 07335 (KR)
(72) Inventor: SEO, Bo-Kyung, Daejeon 34122 (KR); MOON, Chi-Ho, Daejeon 34122 (KR); PARK, Ki-Bum, Daejeon 34122 (KR); CHO, Jae-Young, Daejeon 34122 (KR)
(74) Representative: Plasseraud IP
(86) International application number: PCT/KR2023/000822
(87) International publication number: WO 2023/140593

(56) References cited:
- EP-A1- 2 065 718
- KR-A- 20090 122 470
- KR-A- 20140 134 516
- KR-A- 20150 043 265
- KR-A- 20190 073 065
- KR-A- 20200 030 467
- US-A1- 2016 190 827
- US-A1- 2017 234 930
- US-B1- 10 071 648

## Description

### TECHNICAL FIELD

The present disclosure relates to battery technology, and more specifically, to a technology for effectively controlling charging and discharging of a battery.

### BACKGROUND ART

Batteries are widely used in various fields, such as electric vehicles (EV, HEV, PHEV) and large-capacity energy storage systems (ESS), as well as mobile devices such as mobile phones, laptop computers, smartphones, and smart pads.

The battery includes one or more secondary batteries, and may be mounted in devices such as electronic devices, vehicles, and energy storage systems in the form of a battery module or a battery pack. In addition, the battery pack or the like may further include electrical components such as a battery management system (BMS) or a case in addition to the secondary battery. Here, the secondary battery means a battery that can be charged and discharged, unlike a primary battery that cannot be charged.

So far, various types of batteries have been developed as secondary batteries, but the battery whose utilization area is greatly increasing at the present would be a lithium secondary battery. In particular, the lithium secondary battery has a higher capacity compared to a nickel-cadmium battery or a nickel-hydrogen battery, and also has several advantages, such as high energy density per unit weight and easy high output.

The secondary battery included in the battery may generate electrical energy through electrochemical oxidation and reduction reactions. Such a secondary battery may deteriorate due to various causes in the process of repeating charging and discharging in general. Therefore, the battery may be regarded as not being used permanently and having a limited lifespan.

So far, attempts to increase battery life have been made in various aspects. However, it cannot be said that a sufficient lifespan of the battery has been secured yet, and the demand for a long lifespan battery still continues.

Examples and embodiments from the prior art are presented in the documents US 2016/190827 A1, US 2017/234930 A1, EP 2 065 718 A1, US 10 071 648 B1.

### DISCLOSURE

### Technical Problem

The present disclosure is designed to solve the problems of the related art, and therefore the present disclosure is directed to providing an effective charging and discharging control technology capable of improving the lifespan of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

The present invention is defined by the independent claims. Preferred embodiments of the invention are defined by the dependent claims. There is provided a battery control apparatus, comprising: a memory unit configured to store a criterion voltage for a battery; a measuring unit configured to measure a voltage of the battery during a charging or discharging process of the battery; and a processor configured to compare the measured voltage and the criterion voltage during the charging or discharging process of the battery and change a charging C-rate or a discharging C-rate for the battery when the measured voltage corresponds to the criterion voltage.

Here, the memory unit may store different criterion voltages for the charging process and the discharging process, respectively.

The processor is configured to perform rapid control so that the battery is charged or discharged at a C-rate higher than a C-rate other than the criterion voltage, in a state where the measured voltage corresponds to the criterion voltage.

In addition, the processor may be configured to perform normal control so that the battery is charged or discharged at a C-rate lower than a C-rate in a state of the rapid control for charging or discharging control state, after the rapid control for charging or discharging.

In addition, the processor may be configured to perform idle control so that charging or discharging is stopped for a predetermined time, when the measured voltage enters the criterion voltage.

In addition, the processor may be configured to increase the magnitude of the C-rate while allowing a current to flow in the same direction or to allow the current to flow in an opposite direction, before charging or discharging of the battery ends.

The criterion voltage is determined based on a voltage measured at a phase change time of the battery.

In another aspect of the present disclosure, there is also provided a battery pack, comprising the battery control apparatus according to the present disclosure.

In another aspect of the present disclosure, there is also provided a vehicle, comprising the battery control apparatus according to the present disclosure.

In another aspect of the present disclosure, there is also provided an energy storage system, comprising the battery control apparatus according to the present disclosure.

There is also provided a battery control method, comprising: storing a criterion voltage for a battery; measuring a voltage of the battery during a charging or discharging process of the battery; and comparing the measured voltage and the criterion voltage during the charging or discharging process of the battery and changing a charging C-rate or a discharging C-rate for the battery when the measured voltage corresponds to the criterion voltage.

### Advantageous Effects

According to one embodiment of the present disclosure, charging or discharging of a battery may be effectively controlled.

Therefore, according to this embodiment of the present disclosure, it is possible to control the long lifespan of a battery so as to maintain optimum performance for a long period of time.

In addition, the present disclosure may have various other effects, which will be described in each embodiment, or effects that can be easily inferred by those skilled in the art will not be described in detail.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram schematically showing a functional configuration of a battery control apparatus according to an embodiment of the present disclosure.
FIG. 2 is a graph schematically showing one form of discharging control by the battery control apparatus according to an embodiment of the present disclosure.
FIG. 3 is a graph showing a voltage change over time during charging and discharging according to an embodiment of the present disclosure.
FIG. 4 is a graph showing a voltage change over time during charging and discharging according to a comparative example for comparison with the embodiment of the present disclosure.
FIG. 5 is a graph comparatively showing a degradation measurement result for each cycle according to an embodiment of the present disclosure and a comparative example.
FIG. 6 is a flowchart schematically showing a battery control method according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure. The invention is only defined by the appended claims.

A battery control apparatus according to the present disclosure may be a device for controlling charging and discharging of a battery having a secondary battery, for example a battery pack or a battery module. Here, one or more secondary batteries may be provided in the battery.

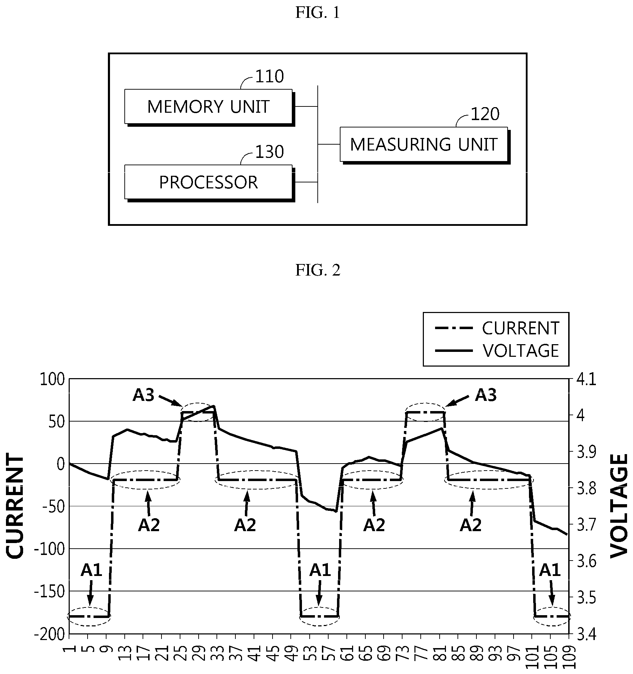

FIG. 1 is a block diagram schematically showing a functional configuration of a battery control apparatus according to an embodiment of the present disclosure.

Referring to FIG. 1, the battery control apparatus according to the present disclosure includes a memory unit 110, a measuring unit 120, and a processor 130.

The memory unit 110 stores a criterion voltage for the battery. Here, the criterion voltage may be a partial voltage specified in the available voltage region of the battery. In particular, the criterion voltage is in the form of a specific voltage region. In particular, the criterion voltage may appear in the form of allowing a certain degree of error range around a specific voltage value, namely in the form of a voltage region. If the criterion voltage has a predetermined range in this way, the criterion voltage may be expressed as a criterion voltage region.

For example, when the available voltage region of the battery is 3.1V to 4.3V, the battery may be changed only up to 4.3V, and discharging of the battery may be controlled to be performed only up to 3.1V. At this time, the criterion voltage may be a voltage corresponding to a part of the available voltage region (3.1V to 4.3V) of the battery, for example 3.77±0.02V. Here, what is expressed as A±0.02V may indicate a range of A-0.02[V] to A+0.02[V]. For example, the criterion voltage of 3.77±0.02V may mean a voltage region of 3.75V to 3.77V.

The criterion voltage may be set in plural for one battery and stored in the memory unit 110. For example, the criterion voltage may be set to at least two of 3.77±0.02V, 3.5±0.02V, and 3.9±0.02V.

In particular, the criterion voltage is a voltage preset as a region in which deterioration of the battery is accelerated, at at a phase change point (phase change time) of a battery (secondary battery), a phenomenon in which battery deterioration is accelerated may occur. In this case, the criterion voltage is set based on the phase change point of the battery. This criterion voltage may be set differently depending on the type of battery, usage type, deterioration state, production deviation, and the like. Accordingly, the memory unit 110 may store criterion voltages classified according to various factors such as the type of battery, usage type, and deterioration state.

In addition, the memory unit 110 may store various data necessary for operating the battery control apparatus of the present disclosure. For example, the memory unit 110 may store programs or data necessary for the measuring unit 120 or the processor 130 to perform its function. The memory unit 110 may be implemented as at least one of a flash memory type, a hard disk type, a solid state disk (SSD) type, a solid disk drive (SDD) type, a multimedia card micro type, a RAM, a SRAM, a ROM, an EEPROM, and a PROM, but the present disclosure is not necessarily limited to the specific form of the memory unit 110.

The measuring unit 120 is configured to measure a voltage of the battery during a charging or discharging process of the battery. In particular, the measuring unit 120 may measure the voltage of the secondary battery included in the battery. To this end, the measuring unit 120 may be connected to both ends of the secondary battery and measure the voltage at both ends of the secondary battery. Moreover, when the battery includes a plurality of secondary batteries, the measuring unit 120 may measure the voltage at both ends of the battery, namely at both ends of the entire secondary battery assembly. Also, in this case, the measuring unit 120 may measure voltages at both ends of some secondary batteries, for example each secondary battery.

The measuring unit 120 may be electrically connected to other components of the battery control apparatus so as to transmit and receive electrical signals. In particular, the measuring unit 120 may transmit voltage measurement information of the secondary battery to the processor 130 so that the processor 130 uses the corresponding information. In addition, the measuring unit 120 may transmit the measured voltage information to the memory unit 110 to be stored. The measuring unit 120 may be implemented with a voltage measuring circuit or voltage sensor commonly used in the art, and the present disclosure is not limited to specific embodiments of the measuring unit 120.

The processor 130 is configured to compare the measured voltage and the criterion voltage during a charging or discharging process of the battery. To this end, the processor 130 may be connected to the memory unit 110 and the measuring unit 120 to receive information from the memory unit 110 and the measuring unit 120. That is, the processor 130 may access criterion voltage information stored in the memory unit 110. Also, the processor 130 may receive voltage information measured for the battery from the measuring unit 120.

In addition, the processor 130 is configured to change a C-rate for the battery according to the comparison result. The processor 130 is configured to change a charging C-rate or a discharging C-rate for the battery when the measured voltage corresponds to the criterion voltage. Here, when the measured voltage corresponds to the criterion voltage, this means that the measured voltage belongs to a region set as the criterion voltage.

For example, if the criterion voltage stored in the memory unit 110 is 3.77V±0.02V, namely 3.75V to 3.79, during the charging or discharging process of the battery, it is possible to judge whether the measured voltage of the battery falls within the range of 3.75V to 3.79V. In this case, if the measured voltage of the battery falls within the range of 3.75V to 3.79V, the processor 130 may change the charging C-rate in the charging state and change the discharging C-rate in the discharging state.

According to this embodiment of the present disclosure, by performing efficient charging and discharging control in a voltage region where battery deterioration may be accelerated, such as a phase change point, it is possible to prevent a battery lifespan from rapidly deteriorating. Therefore, in this case, a long-life battery may be more easily implemented.

The memory unit 110 may be configured to store differently set criterion voltages for the charging process and the discharging process, respectively.

For example, the memory unit 110 may store information in which the criterion voltage is set to 3.77±0.02V and 3.90±0.02V for the charging process. Also, the memory unit 110 may store information in which the criterion voltage is set to 3.50±0.02V and 3.77±0.02V for the discharging process.

In this configuration, the processor 130 may be configured to change the C-rate in different forms by distinguishing the charging process and the discharging process of the battery.

In addition, the processor 130 is configured to perform rapid control so that the battery is charged and discharged at a C-rate with a higher magnitude than a C-rate other than the criterion voltage, in a state where the measured voltage corresponds to the criterion voltage.

For example, when the criterion voltage set for the discharging process is 3.50±0.02V and 3.77±0.02V, in a state where the voltage of the battery is other than 3.50±0.02V and 3.77±0.02V during the discharging process of the battery, the processor 130 may control discharging so that the battery is discharged at a C-rate of C/3. Also, in a state where the voltage of the battery is 3.50 ± 0.02V and 3.77 ± 0.02V, the processor 130 may control discharging so that the battery is discharged at a C-rate of 3C.

Moreover, the processor 130 may control the charging and discharging C-rate according to the voltage change over time while continuously measuring the information on the voltage of the battery by the measuring unit 120. For example, the processor 130 may change the discharging C-rate to 3C, when the voltage of the battery becomes 3.79V while the battery is being discharging at a C-rate of C/3 in a state where the criterion voltage is set to 3.77±0.02V. In addition, the processor 130 may continuously control the battery to be discharged at a C-rate of 3C until the battery becomes 3.75V.

In addition, the processor 130 may be configured to perform normal control so that the battery is charged or discharged at a C-rate with a lower magnitude than the C-rate in a state of the rapid control for charging or discharging, after the rapid control for charging or discharging.

For example, as in this embodiment, in a state where the battery is rapidly discharged at a C-rate of 3C, if the measured voltage of the battery reaches a predetermined voltage, the processor 130 may reduce the discharging C-rate to C/3 based on the measured voltage of the battery.

As a more specific example, in an embodiment in which the criterion voltage is set to 3.77±0.02V, the processor 130 may lower the discharging C-rate from 3C to C/3 when the battery continues to be discharged and its voltage becomes 3.75V.

In addition, the processor 130 may be configured to perform switching control that makes the battery be charged or discharged so that a flow direction of the current is reversed, after the rapid charging and discharging control.

For example, in this embodiment, after the battery is normally controlled from a C-rate of 3C to a C-rate of C/3, the processor 130 may control the battery to be charged at a C-rate of 1C. That is, the processor 130 may perform charging and discharging control for the battery from a discharging state to a charging state.

According to this configuration of the present disclosure, the discharging or charging speed may be controlled in a normal state by compensating for the rapid control that performs discharging at a high C-rate such as 3C. For example, in this embodiment, although there is a rapid discharging control point of 3C, the average discharging C-rate may be maintained at a normal discharging C-rate, such as a C-rate of C/3, by controlling the battery to be charged for a predetermined period of time.

Moreover, the processor 130 may be configured so that the C-rate in the switching control state has a smaller absolute magnitude than the C-rate in the rapid control state.

For example, when the discharging C-rate is 3C during rapid control as in this embodiment, after performing normal control from the rapid control, when performing switching control, the processor 130 may control the charging C-rate to be C/3, which is a C-rate having a smaller magnitude than 3C.

According to this embodiment of the present disclosure, it is possible to prevent deterioration causes such as lithium plating from occurring in the switching control process.

In an embodiment in which the switching control is performed, the processor 130 may determine a switching control execution time based on a rapid control execution time. For example, when rapid control in which discharging is performed for 5 seconds at a C-rate of 3C for the battery is performed, in order to compensate for this rapid control, the processor 130 may perform a control operation so that the battery is charged for 15 seconds at a C-rate of 1C as a switching control.

FIG. 2 is a graph schematically showing one form of discharging control by the battery control apparatus according to an embodiment of the present disclosure.

In FIG. 2, a graph of current and voltage changes over time is shown. In FIG. 2, the horizontal axis represents time (s), and the vertical axis represents current (A, left) and voltage (V, right).

Referring to FIG. 2, a region indicated by A1 in the current graph may be referred to as a region in which the rapid control described above is performed. For example, in the A1 region, it may be regarded that rapid discharging is performed at a C-rate of 3C.

In addition, a region indicated by A2 in the current graph of FIG. 2 may be referred to as a region in which the normal control described above is performed. That is, according to an embodiment of the present disclosure, after rapid charging and discharging control, normal control in which the battery is charged and discharged at a C-rate with a relatively low magnitude may be performed, and the region A2 may be a region where such a normal control is performed. For example, in the region A2, it may be regarded that normal discharging is performed at a C-rate of C/3.

Next, a region indicated by A3 in the current graph of FIG. 2 may be referred to as a region in which the switching control described above is performed. That is, according to an embodiment of the present disclosure, after rapid charging and discharging control, also after normal control is performed, switching control for switching the flow direction of current to an opposite direction may be performed, and the region A3 may be a region where such a switching control is performed. For example, in the region A3, it may be regarded that charging is performed at a C-rate of 1C. That is, even if the battery is in the process of being discharged as a whole, it may be regarded that the battery is temporarily charged in the region A3.

In addition, by such a current control, the voltage of the battery may show a form as shown in FIG. 2.

In addition, the processor 130 may be configured to perform idle control so that charging or discharging is stopped for a predetermined time, if the measured voltage enters the criterion voltage.

For example, when the criterion voltage for charging is set to 3.77V (±0.02V), in the process of charging the battery, the processor 130 may stop charging for a predetermined time when the measured voltage of the battery becomes 3.77V. As a more specific example, the processor 130 may stop charging of the battery for 30 minutes when the measured voltage of the battery becomes 3.77V during the charging process of the battery.

According to this embodiment of the present disclosure, it is possible to eliminate or reduce the charge drifting phenomenon in the inside of the battery, namely in the secondary battery. Therefore, in this case, it is possible to alleviate deterioration of the battery.

In addition, the processor 130 may be configured to increase the magnitude of the C-rate while allowing the current to flow in the same direction or to allow the current to flow in an opposite direction, before charging or discharging of the battery ends. In particular, such a control may be performed when an end signal for charging or discharging is received in a state where the voltage of the battery corresponds to the criterion voltage.

For example, in the charging process of the battery, when the criterion voltage is 3.77V (±0.02V) and 3.90V (±0.02V), if the measured voltage of the battery is within 3.77V (±0.02V) or 3.90V (±0.02V), for example 3.90V, the processor 130 may increase the charging C-rate when a termination signal for the battery is received. Also, the processor 130 may perform charging at the increased charging C-rate, so that charging is terminated in a state where the battery has a voltage greater than 3.92V.

Alternatively, in this embodiment, the processor 130 may apply a current in a reverse direction so that the end voltage becomes a voltage lower than the criterion voltage while resolving the concentrated charges. For example, in a state where the criterion voltage is 3.77V (±0.02V) and 3.90V (±0.02V), when the measured voltage of the battery is 3.90V, a discharging current may flow through the battery so that the battery ends charging with a voltage lower than 3.88V.

That is, according to this embodiment, when the charging and discharging end signal is received in a state where the battery voltage is within the criterion voltage, rapid control or reverse current control may be performed by the processor 130, so that charging or discharging ends in a state where the battery voltage is out of the criterion voltage.

The processor 130 may perform a control operation such as increasing the C-rate magnitude or inducing a current in the opposite direction, if a use end signal for the battery is received. Alternatively, the processor 130 may predict a use end time for the battery and perform a control operation such as increasing the C-rate magnitude or inducing a current in the opposite direction before the predicted use end time.

Hereinafter, an embodiment and a comparative example will be described in more detail in order to more clearly explain the effects of battery charging and discharging control according to an embodiment of the present disclosure. However, the embodiment according to the present disclosure may be modified in various ways, and the scope of the present disclosure should not be construed as being limited to the embodiment described in detail below. The embodiment of the present disclosure is provided to more completely explain the present disclosure to a person with average knowledge in the art.

### (Embodiment 1)

A pouch-type lithium secondary battery was prepared, and charging and discharging were performed for a predetermined time. At this time, charging and discharging were repeatedly performed in the following order and conditions.
(1) Charging: CC (Constant Current) charging at 1C to 4.14V.
(2) Idle: rest for 30 minutes.
(3) Discharging: discharging at 5C for 5 seconds → discharging at C/3 for 5 minutes → CC charging at 1C for 15 seconds → discharging at C/3 for 5 minutes. Discharging ends at 3.35V.
(4) Idle: rest for 30 minutes.

In particular, the discharging control in Embodiment 1 may be regarded as being based on the state where the criterion voltage for discharging is set to 3.50V (±0.02V) and 3.76V (±0.02V).

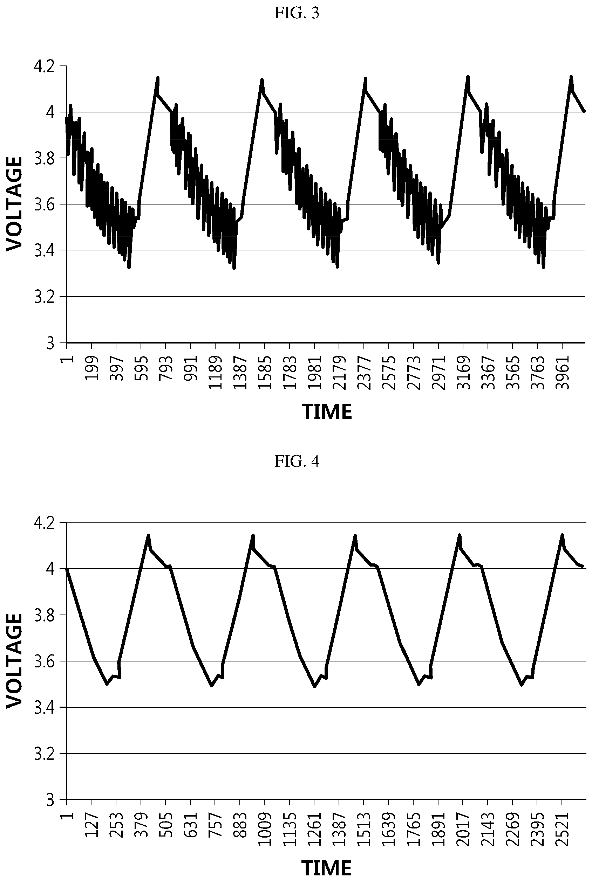

In addition, a graph of voltage change over time according to charging and discharging of Embodiment 1 is shown in FIG. 3. In FIG. 3, the horizontal axis may be regarded as representing time [s] and the vertical axis may be regarded as representing voltage [V].

### (Comparative Example 1)

A pouch-type lithium secondary battery having the same type and specifications as in Embodiment 1 was prepared, and charging and discharging were performed for a predetermined time. At this time, charging and discharging were repeatedly performed in the following order and conditions.
(1) Charging: CC (Constant Current) charging at 1C to 4.14V.
(2) Idle: rest for 30 minutes.
(3) Discharging: discharging at C/3. Discharging ends at 3.35V.
(4) Idle: rest for 30 minutes.

That is, in Comparative Example 1, (1) the charging region, (2) the idle region, and (4) the idle region are performed under the same conditions as in Embodiment 1, but only (3) the discharging region is performed differently.

A graph of voltage change over time according to charging and discharging of Comparative Example 1 is shown in FIG. 4. In FIG. 4, the horizontal axis may be regarded as representing time [s] and the vertical axis may be regarded as representing voltage [V].

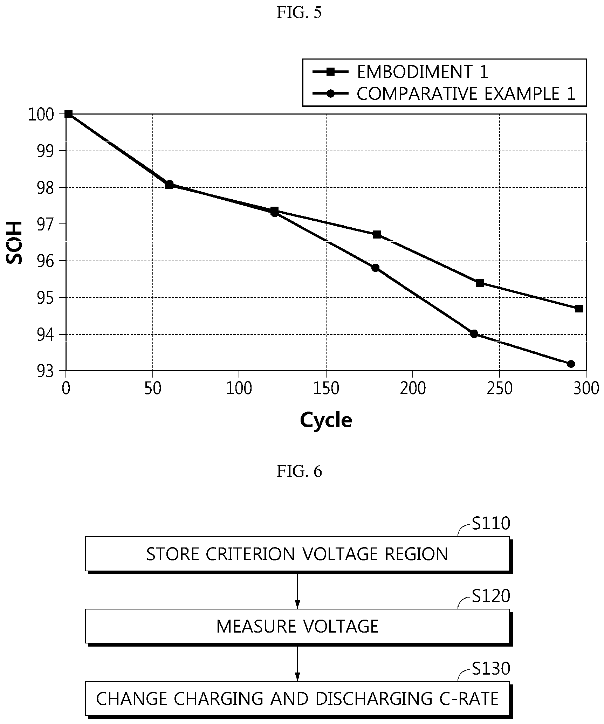

For each secondary battery in which charging and discharging was performed under the conditions of Embodiment 1 and Comparative Example 1, the degradation (SOH) was measured in a method of deriving a ratio of the measured discharging capacity in the range of SOC 0 to 100 of the degraded battery compared to the measured discharging capacity in the range of SOC 0 to 100 of the initial battery, and the result is shown in FIG. 5. That is, FIG. 5 is a graph comparatively showing a degradation measurement result for each cycle according to the embodiment of the present disclosure and the comparative example.

Referring to FIG. 5, it may be regarded that there is no significant difference in the degree of SOH reduction between Embodiment 1 and Comparative Example 1 until a predetermined time point, for example approximately 140 cycles. However, it may be found that from the time point exceeding approximately 150 cycles, the SOH reduction amount of Embodiment 1 shows a difference compared to Comparative Example 1. In particular, in Embodiment 1 and Comparative example 1, it may be found that the SOH difference gradually increases as the charging and discharging cycle is repeated.

Therefore, according to the comparison result, it may be found that the degradation is alleviated when the charging and discharging control according to the embodiment of the present disclosure is performed. Therefore, when the charging and discharging control according to the embodiment of the present disclosure is performed, it may be regarded that long life control for allowing the battery to be used for a longer time is possible.

The processor 130 may be configured to update the criterion voltage stored in the memory unit 110.

Here, the processor 130 derives the criterion voltage using the dQ/dV profile, in which the capacity is first differentiated with respect to voltage, regarding the capacity (Q)-voltage (V) graph obtained in the charging and/or discharging process of the battery. In particular, the phase change points of the positive and negative electrodes of the battery are expressed as peaks in the dQ/dV profile. Accordingly, the processor 130 searches for a peak in the dQ/dV profile and derive a criterion voltage for a certain error range, for example a range of up to ±20 mV, based on the searched peak. Also, the processor 130 may update the criterion voltage derived in this way as a new criterion voltage in the memory unit 110.

In particular, peaks in the dQ/dV profile may be different for each type of battery or for the type of use or condition when the type of battery is the same. For example, when batteries of the same type and specification are installed in multiple vehicles, peak shapes may vary for individual vehicles. In particular, since various conditions such as degradation, a proportion of rapid charging, and a driving pattern of each vehicle may vary, the form of the dQ/dV profile for a battery installed in each individual vehicle and, moreover, the location of a peak may be different.

In this embodiment, although the initial criterion voltage for the battery is stored in the memory unit 110, the criterion voltage may be adaptively updated according to the use condition or shape of the battery. Therefore, according to this embodiment, since more accurate criterion voltages are individually presented, charging and discharging may be more effectively controlled based thereon.

A battery pack according to the present disclosure includes the battery control apparatus according to the present disclosure. In addition, the battery pack according to the present disclosure may further include components normally included in a battery pack, in addition to the battery control apparatus. For example, the battery pack according to the present disclosure may include one or more secondary batteries (battery cells), various electrical components (BMS, relays, fuses, etc.), and a pack case. Moreover, at least some components of the battery control apparatus according to the present disclosure may be implemented using components included in a conventional battery. For example, the processor 130 of the battery control apparatus according to the present disclosure may be implemented by a battery management system (BMS) included in a battery pack.

In addition, a vehicle according to the present disclosure includes the battery control apparatus according to the present disclosure described above. In addition, the vehicle according to the present disclosure may further include components normally included in a vehicle, in addition to the battery control apparatus. For example, the vehicle according to the present disclosure may include a contactor, an inverter, a motor, one or more ECUs, and the like, in addition to the battery control apparatus according to the present disclosure. However, the present disclosure is not particularly limited to components of the vehicle other than the battery control apparatus.

In addition, an energy storage system (ESS) according to the present disclosure includes the battery control apparatus according to the present disclosure. In addition, the energy storage system according to the present disclosure may further include components normally included in an energy storage system, in addition to the battery control apparatus.

FIG. 6 is a flowchart schematically showing a battery control method according to an embodiment of the present disclosure. In FIG. 6, the subject performing each step may be each component of the battery control apparatus according to the present disclosure described above.

Referring to FIG. 6, the battery control method according to the present disclosure includes a storing step (S110), a measuring step (S120), and a C-rate changing step (S130).

Step S110 is a step of storing a criterion voltage for a battery. In addition, Step S120 is a step of measuring a voltage of the battery during a charging or discharging process of the battery. In Step S130, during the charging or discharging process of the battery, the measured voltage is compared with the criterion voltage, and if the measured voltage corresponds to the criterion voltage, a charging C-rate or a discharging C-rate for the battery is changed.

For the operation of each of Steps S110 to S130, the contents described for the memory unit 110, the measuring unit 120, and the processor 130 may be applied identically or similarly. Therefore, the operation is not described in detail here.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description. However, the invention is solely defined by the appended claims.

### Reference Signs

110: memory unit
120: measuring unit
130: processor

## Claims

1. A battery control apparatus, comprising:
a memory unit (110) configured to store a criterion voltage for a battery;
a measuring unit (120) configured to measure a voltage of the battery during a charging or discharging process of the battery; and
a processor (130) configured to compare the measured voltage of the battery and the criterion voltage during the charging or discharging process of the battery and change a charging C-rate or a discharging C-rate for the battery when the measured voltage of the battery corresponds to the criterion voltage,
**characterized in that** the criterion voltage is in the form of a specific voltage region
and is determined based on a voltage of the battery measured at a phase change point of the battery,
wherein the phase change point is a peak in a dQ/dV profile obtained in the charging and/or discharging process of the battery, where Q is capacity and V is voltage,
wherein, in a state where the measured voltage of the battery corresponds to the criterion voltage, the processor is configured to perform rapid control in which the battery is charged or discharged at a C-rate higher than that for voltages outside of the criterion voltage.

2. The battery control apparatus according to claim 1,
wherein the memory unit is configured to store a plurality of different criterion voltages for each of the charging process and the discharging process, respectively.

3. The battery control apparatus according to claim 1,
wherein the processor is configured to perform normal control so that the battery is charged or discharged at a C-rate lower than a C-rate in a state of the rapid control for charging or discharging, after the rapid control for charging or discharging.

4. The battery control apparatus according to claim 1,
wherein the processor is configured to perform idle control so that charging or discharging is stopped for a predetermined time, when the measured voltage enters the criterion voltage.

5. The battery control apparatus according to claim 1,
wherein the processor is configured to increase the magnitude of the C-rate while allowing a current to flow in the same direction or to allow the current to flow in an opposite direction, when an end signal for charging or discharging is received in a state where the voltage of the battery corresponds to the criterion voltage.

6. A battery pack, comprising one or more secondary batteries and the battery control apparatus according to any one of claims 1 to 5.

7. A vehicle, comprising the battery control apparatus according to any one of claims 1 to 5.

8. An energy storage system, comprising the battery control apparatus according to any one of claims 1 to 5.

9. A battery control method, comprising:
Storing (S110) a criterion voltage for a battery;
measuring (S120) a voltage of the battery during a charging or discharging process of the battery; and
comparing the measured voltage of the battery and the criterion voltage during the charging or discharging process of the battery and changing (S130) a charging C-rate or a discharging C-rate for the battery when the measured voltage of the battery corresponds to the criterion voltage,
**characterized in that** the criterion voltage is in the form of a specific voltage region and is determined based on a voltage of the battery measured at a phase change point of the battery,
wherein the phase change point is a peak in a dQ/dV profile obtained in the charging and/or discharging process of the battery, where Q is capacity and V is voltage,
wherein, in a state where the measured voltage of the battery corresponds to the criterion voltage, the processor is configured to perform rapid control in which the battery is charged or discharged at a C-rate higher than that for voltages outside of the criterion voltage.

## Patentansprüche

1. Batteriesteuerungsvorrichtung, umfassend:
eine Speichereinheit (110), welche dazu eingerichtet ist, eine Kriteriumsspannung für eine Batterie zu speichern;
eine Messeinheit (120), welche dazu eingerichtet ist, eine Spannung der Batterie während eines Lade- oder Entladevorgangs der Batterie zu messen; und
einen Prozessor (130), welcher dazu eingerichtet ist, die gemessene Spannung der Batterie und die Kriteriumsspannung während des Lade- oder Entladevorgangs der Batterie zu vergleichen und eine Lade-C-Rate oder eine Entlade-C-Rate für die Batterie zu ändern, wenn die gemessene Spannung der Batterie der Kriteriumsspannung entspricht,
**dadurch gekennzeichnet, dass** die Kriteriumsspannung in der Form eines spezifischen Spannungsbereichs vorliegt und auf Grundlage einer an einem Phasenübergangspunkt der Batterie gemessenen Spannung der Batterie bestimmt wird,
wobei der Phasenübergangspunkt ein Peak in einem in dem Lade- und/oder Entladevorgang der Batterie erhaltenen dQ/dV-Profil ist, wobei Q eine Kapazität ist und V eine Spannung ist,
wobei, in einem Zustand, in welchem die gemessene Spannung der Batterie der Kriteriumsspannung entspricht, der Prozessor dazu eingerichtet ist, eine Schnellsteuerung durchzuführen, bei welcher die Batterie mit einer C-Rate geladen oder entladen wird, welche höher ist als diejenige für Spannungen außerhalb der Kriteriumsspannung.

2. Batteriesteuerungsvorrichtung nach Anspruch 1,
wobei die Speichereinheit dazu eingerichtet ist, eine Mehrzahl verschiedener Kriteriumsspannungen für jeden aus dem Ladevorgang bzw. dem Entladevorgang zu speichern.

3. Batteriesteuerungsvorrichtung nach Anspruch 1,
wobei der Prozessor dazu eingerichtet ist, eine Normalsteuerung derart durchzuführen, dass die Batterie nach der Schnellsteuerung zum Laden oder Entladen mit einer C-Rate geladen oder entladen wird, welche niedriger ist als eine C-Rate in einem Zustand der Schnellsteuerung zum Laden oder Entladen.

4. Batteriesteuerungsvorrichtung nach Anspruch 1,
wobei der Prozessor dazu eingerichtet ist, eine Leerlaufsteuerung derart durchzuführen, dass ein Laden oder Entladen für eine vorbestimmte Zeit gestoppt wird, wenn die gemessene Spannung die Kriteriumsspannung erreicht.

5. Batteriesteuerungsvorrichtung nach Anspruch 1,
wobei der Prozessor dazu eingerichtet ist, den Wert der C-Rate zu erhöhen, während er ermöglicht, dass ein Strom in der gleichen Richtung fließt, oder zu ermöglichen, dass der Strom in einer entgegengesetzten Richtung fließt, wenn ein Endsignal zum Laden oder Entladen in einem Zustand empfangen wird, in welchem die Spannung der Batterie der Kriteriumsspannung entspricht.

6. Batteriepack, umfassend eine oder mehrere Sekundärbatterien und die Batteriesteuerungsvorrichtung nach einem der Ansprüche 1 bis 5.

7. Fahrzeug, umfassend die Batteriesteuerungsvorrichtung nach einem der Ansprüche 1 bis 5.

8. Energiespeichersystem, umfassend die Batteriesteuerungsvorrichtung nach einem der Ansprüche 1 bis 5.

9. Batteriesteuerungsverfahren, umfassend:
Speichern (S110) einer Kriteriumsspannung für eine Batterie;
Messen (S120) einer Spannung der Batterie während eines Lade- oder Entladevorgangs der Batterie; und
Vergleichen der gemessenen Spannung der Batterie und der Kriteriumsspannung während des Lade- oder Entladevorgangs der Batterie und Ändern (S130) einer Lade-C-Rate oder eine Entlade-C-Rate für die Batterie, wenn die gemessene Spannung der Batterie der Kriteriumsspannung entspricht,
**dadurch gekennzeichnet, dass** die Kriteriumsspannung in der Form eines spezifischen Spannungsbereichs vorliegt und auf Grundlage einer an einem Phasenübergangspunkt der Batterie gemessenen Spannung der Batterie bestimmt wird,
wobei der Phasenübergangspunkt ein Peak in einem in dem Lade- und/oder Entladevorgang der Batterie erhaltenen dQ/dV-Profil ist, wobei Q eine Kapazität ist und V eine Spannung ist,
wobei, in einem Zustand, in welchem die gemessene Spannung der Batterie der Kriteriumsspannung entspricht, der Prozessor dazu eingerichtet ist, eine Schnellsteuerung durchzuführen, bei welcher die Batterie mit einer C-Rate geladen oder entladen wird, welche höher ist als diejenige für Spannungen außerhalb der Kriteriumsspannung.

## Revendications

1. Appareil de commande de batterie, comprenant :
une unité mémoire (110) configurée pour stocker une tension critère pour une batterie ;
une unité de mesure (120) configurée pour mesurer une tension de la batterie lors d'un processus de charge ou de décharge de la batterie ; et
un processeur (130) configuré pour comparer la tension mesurée de la batterie et la tension critère pendant le processus de charge ou de décharge de la batterie et modifier un taux C de charge ou un taux C de décharge pour la batterie lorsque la tension mesurée de la batterie correspond à la tension critère,
**caractérisé en ce que** la tension critère se présente sous la forme d'une région de tension spécifique et est déterminée sur la base d'une tension de la batterie mesurée au niveau d'un point de changement de phase de la batterie,
dans lequel le point de changement de phase est un pic dans un profil dQ/dV obtenu au cours du processus de charge et/ou de décharge de la batterie, Q étant la capacité et V étant la tension,
dans lequel, dans un état où la tension mesurée de la batterie correspond à la tension critère,
le processeur est configuré pour effectuer une commande rapide dans laquelle la batterie est chargée ou déchargée à un taux C supérieur à celui pour des tensions en dehors de la tension critère.

2. Appareil de commande de batterie selon la revendication 1,
dans lequel l'unité mémoire est configurée pour stocker une pluralité de tensions critères différentes pour chacun du processus de charge et du processus de décharge, respectivement.

3. Appareil de commande de batterie selon la revendication 1,
dans lequel le processeur est configuré pour effectuer une commande normale de sorte que la batterie soit chargée ou déchargée à un taux C inférieur à un taux C dans un état de la commande rapide pour la charge ou la décharge, après la commande rapide pour la charge ou la décharge.

4. Appareil de commande de batterie selon la revendication 1,
dans lequel le processeur est configuré pour effectuer une commande de ralenti de sorte que la charge ou la décharge soit arrêtée pendant un temps prédéterminé, lorsque la tension mesurée entre dans la tension critère.

5. Appareil de commande de batterie selon la revendication 1,
dans lequel le processeur est configuré pour augmenter l'amplitude du taux C tout en permettant à un courant de circuler dans la même direction ou pour permettre au courant de circuler dans une direction opposée, lorsqu'un signal de fin de charge ou de décharge est reçu dans un état où la tension de la batterie correspond à la tension critère.

6. Bloc-batterie, comprenant une ou plusieurs batteries secondaires et l'appareil de commande de batterie selon l'une quelconque des revendications 1 à 5.

7. Véhicule, comprenant l'appareil de commande de batterie selon l'une quelconque des revendications 1 à 5.

8. Système de stockage d'énergie, comprenant l'appareil de commande de batterie selon l'une quelconque des revendications 1 à 5.

9. Procédé de commande de batterie, comprenant :
le stockage (S110) d'une tension critère pour une batterie ;
la mesure (S120) d'une tension de la batterie lors d'un processus de charge ou de décharge de la batterie ; et
la comparaison de la tension mesurée de la batterie et de la tension critère pendant le processus de charge ou de décharge de la batterie et la modification (S130) d'un taux C de charge ou d'un taux C de décharge pour la batterie lorsque la tension mesurée de la batterie correspond à la tension critère,
**caractérisé en ce que** la tension critère se présente sous la forme d'une région de tension spécifique et est déterminée sur la base d'une tension de la batterie mesurée au niveau d'un point de changement de phase de la batterie,
dans lequel le point de changement de phase est un pic dans un profil dQ/dV obtenu au cours du processus de charge et/ou de décharge de la batterie, Q étant la capacité et V étant la tension,
dans lequel, dans un état où la tension mesurée de la batterie correspond à la tension critère,
le processeur est configuré pour effectuer une commande rapide dans laquelle la batterie est chargée ou déchargée à un taux C supérieur à celui pour des tensions en dehors de la tension critère.
